# EUROPEAN PATENT SPECIFICATION

(11) **EP 0 634 501 B1**
(45) Date of publication and mention of the grant of the patent: **22.09.1999**
(21) Application number: 94905851.5
(22) Date of filing: 04.02.1994
(51) Int. Cl.: C23C 16/52, C23C 16/54

(54) **VACUUM FILM FORMING METHOD**
VERFAHREN ZUR HERSTELLUNG DÜNNER FILME UNTER VAKUUM
PROCEDE DE FORMATION DE FILMS SOUS VIDE

(30) Priority: 05.02.1993 JP 1893093
(43) Date of publication of application: 18.01.1995
(73) Proprietor: KABUSHIKI KAISHA TOSHIBA, Kawasaki-shi, Kanagawa-ken 210-8572 (JP)
(72) Inventor: HIRATA, Noriyuki, Ayase-shi, Kanagawa-ken 252 (JP)
(74) Representative: Henkel, Feiler, Hänzel
(86) International application number: JP9400171
(87) International publication number: WO9418358

(56) References cited:
- EP-A- 0 144 229
- JP-A- 3 287 773
- JP-A- 60 165 379
- JP-A- 63 115 326
- US-A- 4 911 103

## Description

### [Technical Field]

The present invention relates to a vapor deposition method of forming film on a substrate.

### [Background Art]

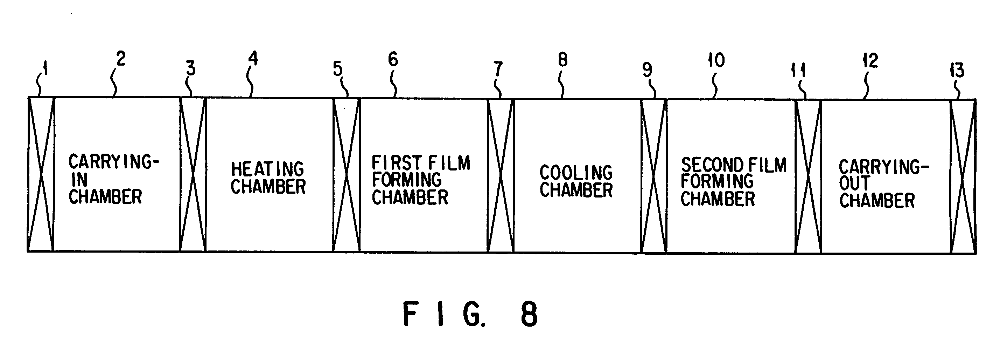

In the case where thin film is formed on a substrate to make a thin film transistor, for example, the chemical vapor deposition (CVD) apparatus of the continuous in-line type as shown in FIG. 8 is usually used.

As shown in FIG. 8, this chemical vapor deposition apparatus has a gate valve 1, to which a carry-in chamber 2 into which a substrate is carried through the gate valve 1 is connected. A heating chamber 4 in which the substrate is heated is also connected to the carry-in chamber 2 through a gate valve 3. Further, a first film forming chamber 6 in which thin film is formed on the substrate is connected to the heating chamber 4 through a gate valve 5 and a cooling chamber 8 in which the heated substrate is cooled is connected to the first heating chamber 6 through a gate valve 7. Furthermore, a second film forming chamber 10 in which thin film is again formed on the substrate is connected to the cooling chamber 8 through a gate valve 9 and a carry-out chamber 12 out of which the substrate is carried is connected to the second film forming chamber 10 through a gate valve 11. A gate valve 13 is attached to the other side of the carry-out chamber 12.

The substrate is set at first on a tray and carried into the carry-in chamber 2. It is then carried into the heating chamber 4 while keeping the carry-in chamber 2 vacuum, and it is heated there to a predetermined temperature and carried into the first film forming chamber 6. Material gas is introduced into the first film forming chamber 6 at a predetermined temperature to adjust pressure in the first film forming chamber 6 and thin film is formed on the substrate while adding high frequency current or the like to it. After thin film is thus formed on it in the first film forming chamber 6, the chamber 6 is exhausted to vacuum and it is then carried into the cooling chamber 8. The substrate which has been carried into the cooling chamber 8 is cooled to a predetermined temperature and carried into the second film forming chamber 10. Material gas is introduced into the second film forming chamber 10 at a temperature lower than that in the first film forming chamber 6 to adjust pressure in the chamber 10 and thin film is again formed on the substrate while applying high frequency power or the like to it. After thin film is thus formed on the substrate in the second film forming chamber 10, the chamber 10 is exhausted to vacuum and the substrate is carried into the carry-out chamber 12. Pressure in the chamber 12 is then returned to atmospheric pressure and the film-formed substrate is carried out of the chamber 12 through the gate valve 13.

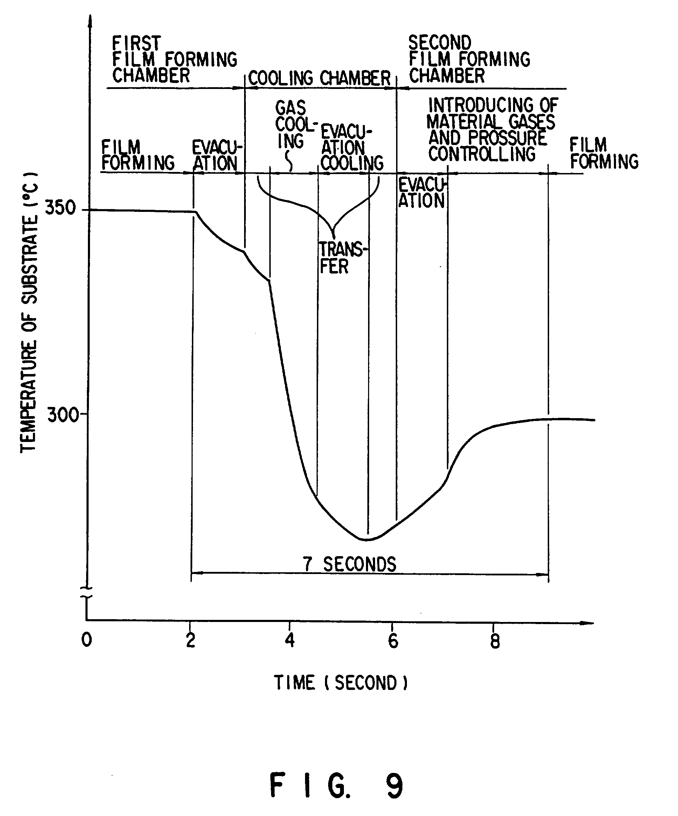

In a case where films are continuously formed on the substrate under two or more different process conditions, however, a cooling or heating chamber used to change substrate temperature is needed between the first and the second film forming chamber, for example. It is also needed that temperatures of the substrate and the tray itself on which the substrate is set are made stable. Since, however, the tray made of stainless steel usually has a large heat capacity, as shown in FIG. 9, it takes quite a long time to make the temperature of the substrate stable.

In the case where film forming is continuously carried out in a single film forming chamber under two or more different conditions, therefore, it takes quite a long time to make the temperature of the substrate stable and this is actually impossible or impractical.

In the case where plural film forming chambers are used, heating or cooling chambers used to change the temperature of the substrate set are needed between the first and the second film forming chamber and between the others. This makes the cost of the apparatus high. In addition, the apparatus becomes large in size and the space which the apparatus occupies also becomes large. Further, it takes a long time to change and stabilize the temperature of the substrate. This makes the productivity of the apparatus low.

The references US-A-4,911,103 and EP-A-0 144 229 both disclose chemical vapor deposition methods which make use of a heater for heating a substrate.

Although the latter reference discloses that a heater is provided in the film-forming chambers, the process of film deposition is carried out in that the film-forming chambers are adjusted to maintain a gas pressure of a certain fixed level while the the glass substrates are heated to the desired temperature.

It is the object of the present invention to provide a vapor deposition method which is improved with respect to the control of the process, particularly with respect to the control of the temperature of the substrate and which requires a smaller and less expensive apparatus.

According to the present invention there is provided a vapor deposition method comprising the steps of: transporting a substrate having a temperature into a film forming chamber provided with a substrate heater that operates at a constant temperature; controlling the temperature of the substrate by controlling the pressure within the film forming chamber within a range of 13.332 Pa (0.1 Torr) to 666.6 Pa (5 Torr) and/or by controlling the transport time of the heated substrate; and vapor-depositing a film on the substrate in the film forming chamber using a film forming gas.

In a preferred embodiment of the method, after the step of vapor-depositing the film on the substrate in the film forming chamber using the film forming gas, one or more additional films are formed on the substrate by repeatedly controlling the temperature of the substrate by controlling the pressure within the film forming chamber within a range of 13.332 Pa (0.1 Torr) to 666.6 Pa (5 Torr) and vapor-depositing a film on the substrate in the film forming chamber using a film forming gas.

Preferrably, before forming an additional film on the substrate, said substrate is transported from said one film forming chamber into another film forming chamber provided with a substrate heater that operates at a constant temperature, wherein the temperature of the substrate is controlled by controlling the pressure within the other film forming chamber within a range of 13.332 Pa (0.1 Torr) to 666.6 Pa (5 Torr) and/or by controlling the transport time of the substrate from said one film forming chamber into another film forming chamber and wherein the additional film is vapor-deposited on the substrate in the other film forming chamber using a film forming gas.

Further preferred embodiments of the method of the invention are defined in the sub-claims.

According to the vapor deposition method of the present invention, the substrate is carried one by one. A tray is thus made unnecessary and when the substrate has a small heat capacity, its temperature can be more easily changed for a shorter time. In addition, its temperature is controlled while keeping the heating temperature of the heater certain and controlling at least one of the value of pressure set in the film forming chamber and the time needed to carry the substrate. This makes it unnecessary to heat and cool the substrate directly. The cost of forming thin film on the substrate can be thus made lower and the temperature of the substrate can be more easily changed.

### [Brief Description of the Drawings]

FIG. 1 is a block diagram showing the chemical vapor deposition apparatus according to an embodiment of the present invention;
FIG. 2 is a block diagram showing first and second film forming chambers;
FIG. 3 is a block diagram showing a transfer chamber;
FIG. 4 is a block diagram showing a heating chamber;
FIG. 5 is a sectional view showing a matrix array substrate which is being made;
FIG. 6 is a graph showing a change in substrate temperature;
FIG. 7 is a graph showing another change in substrate temperature;
FIG. 8 is a block diagram showing the conventional chemical vapor deposition apparatus; and
FIG. 9 is a graph showing a change in substrate temperature in the conventional chemical vapor deposition apparatus.

### [Best Mode of carrying Out the Invention]

The chemical vapor deposition apparatus according to an embodiment of the present invention will be described with reference to the accompanying drawings.

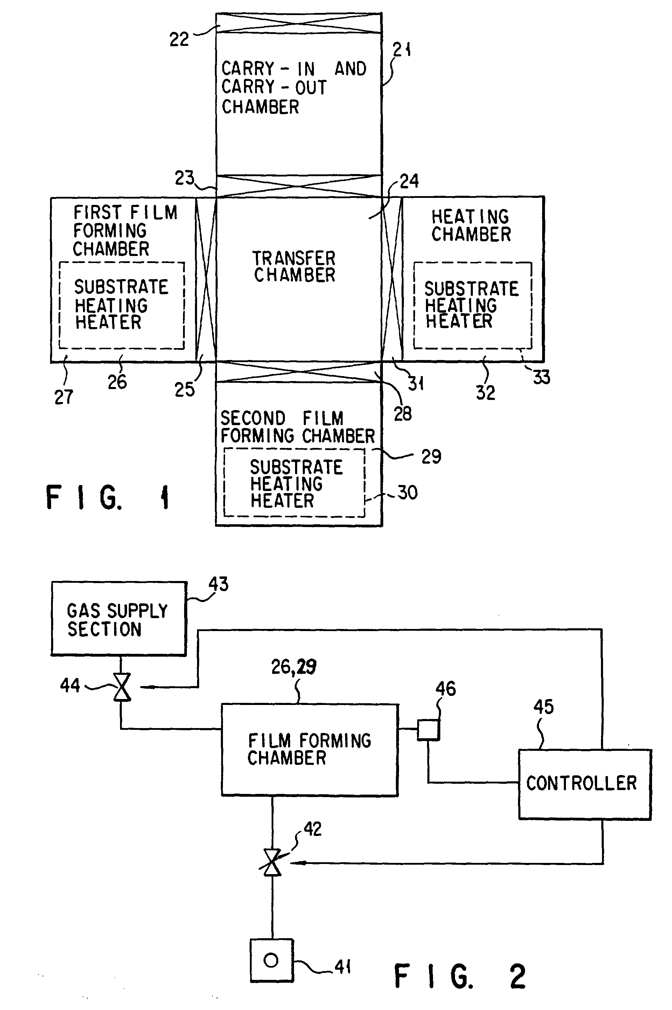

In FIG. 1, reference numeral 21 represents a carry-in and -out chamber. A matrix array substrate B, on which a thin film transistor (TFT) is formed, is carried into and out of the carry-in and -out chamber 21 and a gate valve 22 is attached to a side of the chamber 21 through which the substrate B is carried into and out of the chamber 21. A gate valve 23 is also attached to another side of the chamber 21 which is opposed to the gate-valve-attached side thereof. A transfer chamber 24 is connected to the carry-in and -out chamber 21 through the gate valve 23 and it has a single substrate carrying mechanism for carrying the substrate one by one without using any tray.

A first film forming chamber 26 is connected to a side of the transfer chamber 24, which is different from the side thereof provided with the gate valve 23, through a gate valve 25. It has a substrate heating heater 27 and thin film is formed on the matrix array substrate B in it. A gate valve 28 is attached to a further side of the chamber 24 and a second film forming chamber 29 is connected to the chamber 24 through the gate valve 28. This second film forming chamber 29 also has a substrate heating heater 30 and thin film is formed on the matrix array substrate B in it. A gate valve 31 is also attached to a still further side of the chamber 24 and a heating chamber 32 is connected to the chamber 24 through the gate valve 31. This heating chamber 32 also has a substrate heating heater 33 to heat the matrix array substrate B.

The first and second film forming chambers 26 and 29 are as shown in FIG. 2. A vacuum suction pump 41 is connected to each of the first and second film forming chambers 26 and 29 through a throttle valve 42 and a gas supply section 43 is also connected to it through a switch valve 44. Further, a pressure sensor 46 is connected to it and a controller 45 which serves as control means having a timer is connected to the pressure sensor 46. The controller 45 is also connected to the throttle valve 42 and the switch valve 44 to control them.

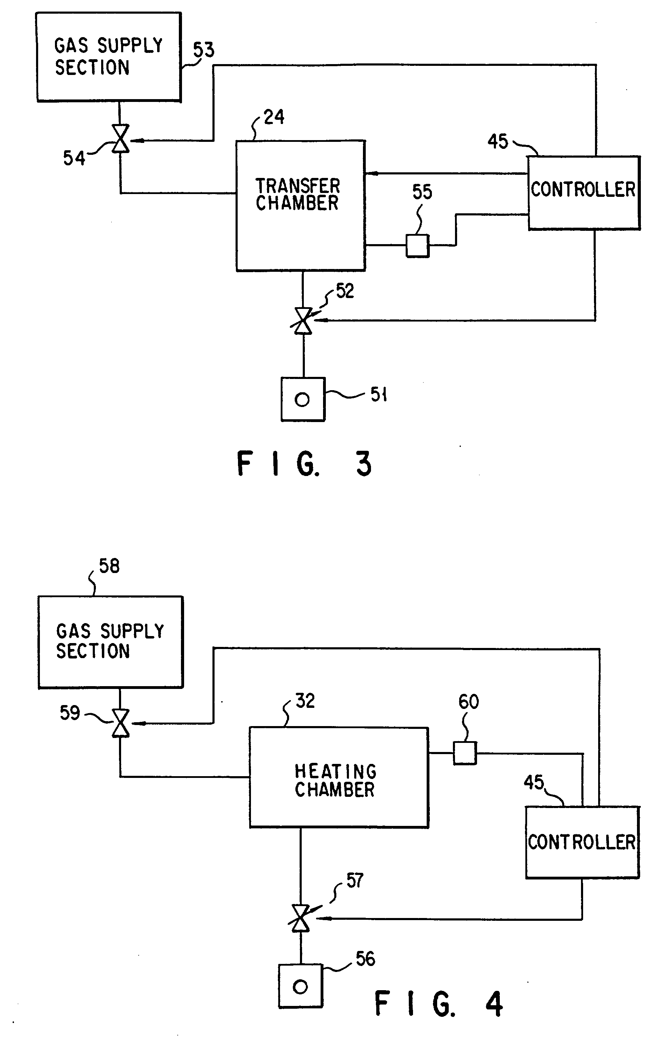

The transfer chamber 24 is as shown in FIG. 3. A vacuum suction pump 51 is connected to the transfer chamber 24 through a throttle valve 52 and a gas supply section 53 is connected to it through a switch valve 54. A pressure sensor 55 is connected to the transfer chamber 24 and the controller 45 is connected to the pressure sensor 55. The controller 45 is also connected to the throttle valve 52 and the switch valve 54 to control them. It also controls the substrate carrying speed.

The heating chamber 32 is as shown in FIG. 4. A vacuum suction pump 56 is connected to the heating chamber 32 through a throttle valve 57 and a gas supply section 58 is also connected to it through a switch valve 59. A pressure sensor 60 is connected to it and the controller 45 is connected to the pressure sensor 60. The controller 45 is also connected to the throttle valve 57 and the switch valve 59 to control them.

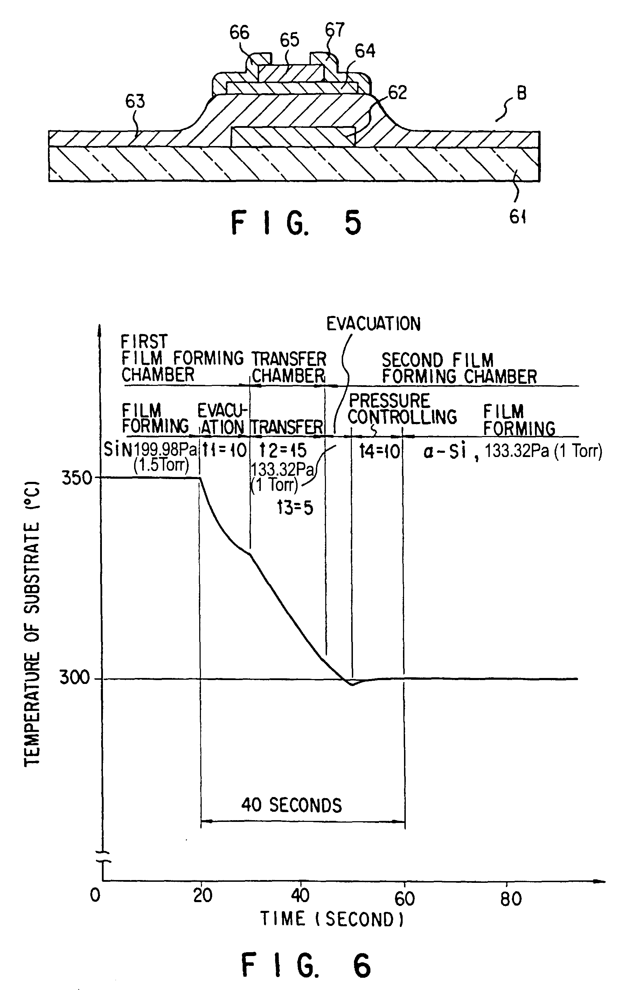

As shown in FIG. 5, the matrix array substrate B comprises a glass substrate 61, a gate electrode 62 formed on the glass substrate 61, a gate insulator layer 63 formed on the glass substrate 61 and the gate electrode 62, semiconductor and etching stopper layers 64 and 65 formed above the gate electrode 62 with the gate insulator layer 63 interposed between them, and source and drain electrodes 66 and 67 formed on the semiconductor and etching stopper layers 64 and 65.

It will be described how the above-described chemical vapor deposition apparatus operates.

All of the gate valves 22, 23, 25, 28 and 31 are closed. Responsive to pressures detected by the pressure sensors 46, 55 and 60, the controller 45 opens the throttle valves 42, 52 and 57 to exhaust vacuum all of the chambers 26, 29 and 32 except the carry-in and -out chamber 21 through the suction pumps 41, 51 and 56 to reach the predetermined pressure. Substrate heating heaters 27, 33 and 30 which are attached to the first film forming chamber 26, the heating chamber 32 and the second film forming chamber 29, respectively, are previously heated to 420°C, 390°C and 350°C, respectively, in vacuum.

The gate valve 22 of the carry-in and -out chamber 21 is opened and the glass substrate 61 for the matrix array substrate B or a cassette in which the glass substrate 61 for the matrix array substrate B is housed is set in the carry-in and -out chamber 21. The gate valve 22 is then closed and the carry-in and -out chamber 21 is evacuated from atmospheric pressure to a predetermined one by the suction pump (not shown). Thereafter, the gate valve 23 of the carry-in and -out chamber 21 which is located on the side of the transfer chamber 24, and the gate valve 31 of the heating chamber 32 are opened and the glass substrate 61 is carried from the carry-in and -out chamber 21 into the heating chamber 32 by the single-substrate carrying mechanism.

When the glass substrate 61 is carried into the heating chamber 32, the gate valve 31 of the heating chamber 32 is closed and the glass substrate 61 is heated to about 380°C on the substrate heating heater 33 and held there. It is further raised in temperature for a predetermined time and after this temperature raising is finished, the throttle valve 57 for the suction pump 56 is opened to evacuate the heating chamber 32. The gate valves 31 and 25 of the heating and first film forming chambers 32 and 26 are then opened. The speed of the single substrate carrying mechanism in the carrier chamber 24 is controlled by the controller 45 and the glass substrate 61 is carried from the heating chamber 32 into the first film forming chamber 26.

When the glass substrate 61 is carried into the first film forming chamber 26, the gate valve 25 of the first film forming chamber 26 is closed and the controller causes the throttle valve 42 for the suction pump 41 to be opened to evacuate the first film forming chamber 26 for a predetermined time. The switch valve 44 for the gas supply section 43 is opened to introduce material gases such as monosilane (SiH₄), ammonia (NH₃) and nitrogen (N₂) into the first film forming chamber 26. The opening of the throttle valve 42 is controlled by the controller 45 to adjust pressure in the first film forming chamber 26 to a predetermined one of 199,98 Pa (1.5 Torr). High frequency power is then applied to generate discharge and the gate insulator layer 63 which is silicon nitride (SiₓN_{y}) film is formed on the entire surface of the glass substrate 61 having the gate electrode 62 formed thereon, at a temperature range of 300°C - 400°C, preferably at 350°C. X and y in silicon nitride (SiₓN_{y}) are usually replaced by 2 and 3 but the film of SiₓN_{y} sometimes includes quite a little amount of hydrogen (H) or oxygen (O) elements. The throttle valve 42 is regarded as an open position when it is made parallel or 180 degrees to the flow of gases and as a close position when it is made perpendicular or 90 degrees to the flow. It is adjusted in a range of 90 - 180 degrees. Before the gate insulator layer 63 is formed on the glass substrate 61, thin film is formed on the substrate 61 and then etched to form the gate electrode 62. When discharge is finished after a predetermined time period, the throttle valve 42 for the suction pump 41 is opened for a predetermined time t₁ to evacuate the first film forming chamber 26. Further, gate valves 25 and 28 of first and second film forming chambers 26 and 29 are opened and while controlling the speed of the single substrate carrying mechanism in the transfer chamber 24 through the controller 45, the glass substrate 61 having the gate insulator layer 63 formed thereon is carried from the first film forming chamber 26 into the second film forming chamber 29 at a time t₂ previously set by the controller 45.

When the glass substrate 61 having the gate insulator layer 63 formed thereon and serving as the matrix array substrate B is carried into the second film forming chamber 29, the gate valve 28 of the second film forming chamber 29 is closed and the throttle valve 42 for the suction pump 41 is opened for a time t₃ previously set to evacuate the second film forming chamber 29. The switch valve 44 for the gas supply section 43 is opened and material gases such as monosilane (SiH₄) and hydrogen (H₂) are introduced into the second film forming chamber 29. While detecting pressure in the chamber 29 through the pressure sensor 46, the opening degree of the throttle valve 42 is controlled to adjust the pressure in the chamber 29 to a predetermined one of 266,67 Pa (2 Torr) in a previously-set time t₄. High frequency power is then applied to generate discharge and the semiconductor layer 64 which is amorphous silicon (a-Si) film is formed on the gate insulator layer 63 to a predetermined thickness in a temperature range of 250°C - 350°C, preferably at 300°C. After the semiconductor layer 64 is formed in this manner, the throttle valve 42 for the suction pump 41 is again opened to evacuate the second film forming chamber 29. The gate valve 28 of the second film forming chamber 29 and the gate valve 23, which is located on the side of the carry-in and -out chamber 21, are opened and the matrix array substrate B having laminated film layers formed in the second film forming chamber 29 is returned into the carry-in and -out chamber 21 by the single substrate carrying mechanism in the transfer chamber 24 one by one.

When the glass substrate 61 having the semiconductor layer 64 formed thereon and serving as the matrix array substrate B is carried into the first 26, the second 29 or other film forming chambers (not shown), the chamber is similarly evacuated and material gases such as monosilane (SiH₄), ammonia (NH₃) and hydrogen (H₂) are introduced into it. After pressure in it is adjusted to a predetermined one of 106,66 Pa (0.8 Torr), high frequency power is applied to generate discharge and the etching stopper layer 65, which is silicon nitride (SiₓN_{y}) film, is formed on the semiconductor layer 64 to a predetermined thickness in a temperature range of 250°C - 350°C, preferably at 290°C. After the etching stopper layer 65 is formed in this manner, the chamber is again evacuated and the glass substrate 61 is then returned into the carry-in and -out chamber 21.

After etching is carried out in a predetermined manner, source and drain electrodes 66 and 67 are formed on semiconductor layer 64.

The above-mentioned processes or steps will be again continuously repeated.

Temperature control will be described citing temperature change in the substrate shown in FIG. 6 wherein two film layers are formed on the substrate in the first 26 and the second film forming chamber 29.

After film forming is finished in the first film forming chamber 26, the throttle valve 42 for the suction pump 41 is opened by the controller 45 to evacuate the first film forming chamber 26 for the time t₁, during which substrate temperature is lowered by about 20°C. Responsive to pressure detected by the pressure sensor 55, pressure in the transfer chamber 24 is adjusted to 133,32 Pa (1 Torr) for the time t₂, during which the substrate is carried from the first film forming chamber 26 into the second film forming chamber 29, by the controller 45. Substrate temperature is thus lowered by about 25°C. Substrate temperature is further lowered in the second film forming chamber 29 by 5°C for the waiting time t₃ and the pressure adjusting time t₄ during which the switch valve 44 for the gas supply section 43 is opened to introduce material gases into the chamber 29.

When the evacuating time t₁ in the first film forming chamber 26, the time t₂ needed to carry the substrate from the first 26 into the second film forming chamber 29, pressure in the transfer chamber 24 at the substrate carrying time t₂, the waiting time t₃ in the second film forming chamber 29, and the pressure adjusting time t₄ for introducing material gases into the second film forming chamber 29 are controlled by memories in the controller 45, as described above, the time needed to control the temperature of the matrix array substrate B can be made the shortest. Pressure at the pressure adjusting may be changed in a step-like manner.

Pressure at the time when film forming was carried out in the first film forming chamber 26 was set 199.98 Pa (1.5 Torr), that in the transfer chamber 24 was set 133.32 Pa (1 Torr), and that at the time when film forming was carried out in the second film forming chamber 29 was set 266.64 Pa (2 Torr). When it is set in this case that t₁ = 10 sec., t₂ = 15 sec., t₃ = 5 sec., and t₄ = 10 sec., temperature control of the matrix array substrate B can be made at the shortest time of about 40 sec..

In the system for controlling substrate temperature while keeping the substrate on each of the substrate heating heaters 27, 30 and 33, the temperature of the matrix array substrate B becomes low on the high vacuum side and high on the low vacuum side when the substrate heating heaters 27, 30 and 33 are set same in temperature. This becomes more remarkable when the clearance between the matrix array substrate B and each of the substrate heating heaters 27, 30 and 33 is smaller than 0.3 mm, and it changes depending upon the kind of gas present in the clearance. When adjusting pressure at the film forming is selected, therefore, film forming is made possible at a desired substrate temperature.

On the other hand, the temperature of the matrix array substrate B becomes different, depending upon the kinds of gases used in the film forming, even though the substrate heating heaters 27, 30 and 33 are set same in temperature. In a case where a SiₓN_{y} film is formed under 466.62 Pa (3.5 Torr) and a a-Si film under 133.32 Pa (1 Torr), while setting the substrate heating heaters 27, 30 and 33 at a temperature of 350°C, for example, the SiₓN_{y} film can be formed when the temperature of the matrix array substrate B is 350°C and the a-Si film when it is 300°C.

In the case where film forming is continuously applied to the matrix array substrate B under two or more different process conditions in the first and second film forming chambers 26 and 29, therefore, pressure at the pressure adjusting in the first film forming chamber 26, the evacuating time and the value of pressure set after the film forming step, the time needed to carry the matrix array substrate B from the first film forming chamber 26 into the second film forming chamber 29 and pressure at this time, the waiting time and the value of pressure set until material gases are introduced into the second film forming chamber 29 to adjust pressure in it, and the value of pressure set at this pressure adjusting time are used as parameters, and when they are set optimum, the time needed to control the temperature of the matrix array substrate B can be made the shortest.

Another embodiment of the present invention wherein different laminated film forming processes are carried in the first film forming chamber 26 will be described. Parallel processes are similarly carried out also in the second film forming chamber 29.

The substrate heating heater 27 in the first film forming chamber 26 is previously set 390°C. Gate valves 23 and 31 of carry-in and -out and heating chambers 21 and 32 are opened and the glass substrate 61 having the gate electrode 62 formed thereon and serving as the matrix array substrate B is carried into the heating chamber 32 by the single substrate carrying mechanism in the transfer chamber 24 and heated to about 380°C. Gate valves 31 and 25 of heating and first film forming chambers 32 and 26 are opened and the substrate, which has been heated to about 380°C in the heating chamber 32, is carried from the heating chamber 32 into the first film forming chamber 26 by the single substrate carrying mechanism in the transfer chamber 24.

When the substrate is carried into the first film forming chamber 26, the gate valve 25 of the first film forming chamber 26 is closed and evacuating is carried out for a predetermined time. The switch valve 44 for the gas supply section 43 is opened by the controller 45 and material gases such as SiH₄, NH₃ and N₂ are introduced into the first film forming chamber 26. While controlling the opening degree of the throttle valve 42 for the suction pump 41 through the controller 45, pressure in the chamber 26 is adjusted to 466.62 Pa (3.5 Torr). High frequency power is applied to generate discharge and the gate insulator layer 63, which is SiₓN_{y} film, is formed on the glass substrate 61 at 350°C.

The throttle valve 42 for the suction pump 41 is opened for a previously-set time by the controller 45 to exhaust the chamber 26 to vacuum. The switch valve 44 for the gas supply section 43 is opened and material gases such as SiH₄ and H₂ are again introduced into the chamber 26. Pressure in it is adjusted to 133.32 Pa (1 Torr) and the semiconductor layer 64, which is a-Si film is, formed on the gate insulator layer 63 at 300°C. In order to control pressure in the chamber 26 at the evacuating time, it may be arranged that material gases continue to be introduced into the chamber 26 while opening the switch valve 44 for the gas supply section 43 through the controller or that high frequency power continues to be applied.

After the semiconductor layer 64 is formed, the throttle valve 42 for the suction pump 41 is opened for a predetermined time by the controller 45 and evacuating is carried out in the chamber 26. The switch valve 44 for the gas supply section 43 is opened and material gases such as SiH₄, NH₃ and H₂ are again introduced into the chamber 26. Pressure in the chamber 26 is adjusted to 66,66 Pa (0.5 Torr) and the etching stopper layer 65, which is SiₓN_{y} film, is formed on the semiconductor layer 64 at 290°C. In order to control pressure at the evacuating time, it may be similarly arranged also in this case that material gases continue to be introduced while opening the switch valve 44 for the gas supply section 43 through the controller 45 or that high frequency power continues to be applied.

After these gate insulator, semiconductor and etching stopper layers 63, 64 and 65 are formed, evacuating is again carried out in the chamber 26. Gate valves 25 and 23 of first film forming and carry-in and -out chambers 26 and 21 are opened and the substrate, on which film layers have been laminated, is returned from the first film forming chamber 26 into the carry-in and -out chamber 21 by the single substrate carrying mechanism in the transfer chamber 24. Same processes or steps are carried out in the second film forming chamber 29.

After the predetermined etching, the source and drain electrodes 66 and 67 are formed.

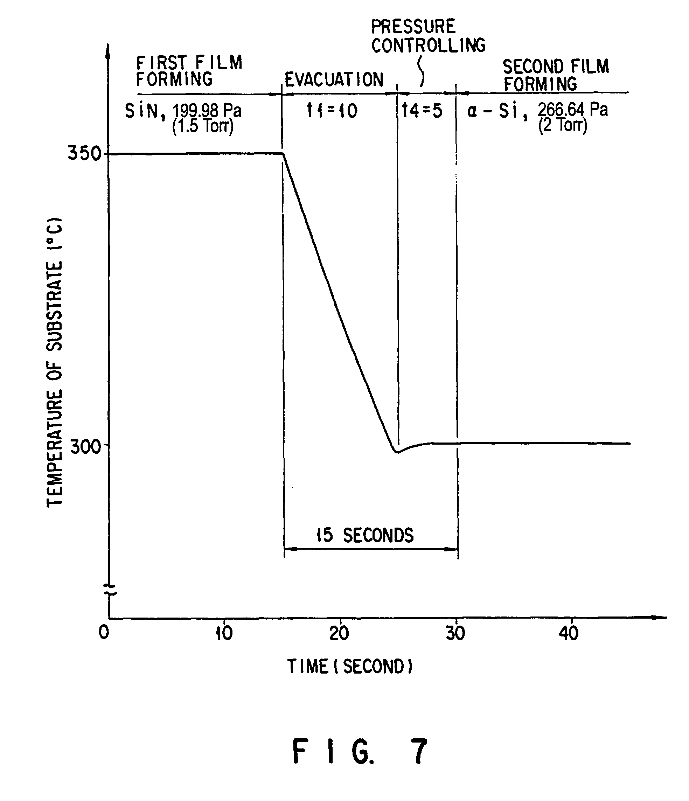

Temperature control of the substrate will be described referring to FIG. 7 which shows temperature change in the substrate caused when the gate insulator and semiconductor layers 63 and 64 are formed in the first film forming chamber 26.

The throttle valve 42 for the suction pump 41 is opened by the controller 45 and the temperature of 350°C, at which SiₓN_{y} film is formed as the first film, is lowered to near 300°C in the first film forming chamber 26 for the evacuating time t₁ (= 10 sec.) after the film forming step. At the same time, the throttle valve 43 for the gas supply section 42 is opened by the controller 45 and the substrate temperature is made stable at 300°C and film forming is carried out in the first film forming chamber 26 for the second a-Si film material gases introducing and pressure adjusting time t₄ (= 5 sec.). The time needed to change substrate setting is 15 sec. in this case. Material gases may continue to be introduced into the first film forming chamber 26 to control time pressure for the evacuating time t₁ and the material gases introducing and pressure adjusting time t₄. In this case, discharging condition may be kept.

In the case where two or more different film forming processes or steps are continuously carried out in the single first film forming chamber 26, therefore, the time needed to control substrate temperature at the film forming step can be made the shortest when the evacuation waiting time until the start of each material gas introducing and pressure adjusting step, the value of pressure set at the pressure adjusting time, and the evacuating time and value of pressure set after the film forming step are set optimum as parameters. When the substrate temperature control method of changing, as parameters, the evacuating time and value of pressure set, the substrate carrying time, and the evacuation waiting time and value of pressure set, and the other method of forming film while changing pressure adjusted at each film forming time are used, the time needed to control substrate temperature can be made the shortest. When film forming is continuously carried out under two or more process conditions, the time needed to control substrate temperature can be made the shortest without using any heating or cooling chamber to change the temperature of the substrate.

According to the above-described embodiment, the time needed to control substrate temperature can be made the shortest without using any heating or cooling chamber to change substrate temperature when the evacuating time t₁ and value of pressure set in the first and second film forming chambers 26 and 29 after the film forming step, the time t₂ for carrying the substrate from the first film forming chamber 26 into the second one 29 by the single substrate carrying mechanism in the transfer chamber 24, the pressure in the transfer chamber at the substrate carrying time, the evacuation waiting time t₃ and value of pressure set before the film forming step, and the material gases introducing and pressure adjusting time t₄ before the film forming step are set optimum and pressure at each film forming step is also set optimum to continuously carry out film forming under different film forming conditions.

Further, film forming is made possible by different substrate temperature processes while setting the substrate heating heaters 27 and 30 same in temperature, and plural different film forming processes can be continuously realized in the same first or second film forming chamber 26 or 29. The chemical vapor deposition apparatus can be thus made lower in cost and smaller in size. In addition, the space the apparatus occupies can be made smaller. The apparatus can also be made by far higher in productivity.

It is more effective in the first or second film forming chamber 26 or 29 that the clearance between the matrix array substrate B and the substrate heating heater 27 or 30 is made smaller than 0.3 mm. When an exhaust system, by which pressure, smaller than 13.332 Pa (10 mTorr), can be attained, is used and pressure at the film forming time is set controllable in a range of 13.332-666.6 Pa (0.1 - 5 Torr), the temperature of the matrix array substrate B, which is SiₓN_{y} film, can be controlled optional in a range of 300°C - 370°C while setting the substrate heating heaters 27 and 30 at 400°C in temperature.

Property change of the amorphous semiconductor, particularly its mobility deterioration can be controlled when temperature at the laminated films forming time after the amorphous semiconductor film forming step is made lower than that at the amorphous semiconductor film forming time particularly in the case where laminated film layers including the amorphous semiconductor film are to be continuously formed. When temperature is successively lowered as seen in the above-described embodiment, therefore, laminated film layers can be continuously formed without changing the property of the amorphous semiconductor layer. This is quite more advantageous in producing thin film transistors.

Although film forming has been carried out while successively lowering the temperature of the matrix array substrate B in the case of the above-described embodiment, film forming temperature may be kept certain or successively raised.

X and y of silicon nitride (SiₓN_{y}) are usually replaced by 1 and 2 but silicon nitride sometimes includes quite a little amount of N or H. Instead of silicon nitride, therefore, silicon oxide (SiₓO_{y}) may be used. The kind of film used can be thus made optional.

Further, semiconductor devices thus produced can be used as solar batteries and others in addition to TFTs.

Furthermore, plural layers of film may be formed in a single film forming chamber, a layer of film may be formed in it or these processes may be combined with each other.

According to the vapor deposition method substrate temperature is controlled to a different one while controlling the value of pressure set in the film forming chamber. Even though the substrate heating heater has a large heat capacity, therefore, substrate temperature can be changed for a shorter time because it is changed while controlling the value of pressure set.

According to the vapor deposition method the temperature of the substrate heating heater is made constant when substrate temperature is to be controlled to a different one. The heating temperature of the substrate heating heater is thus made constant in the film forming chamber. In short, substrate temperature is changed while keeping constant the heating temperature of the substrate heating heater which has a large heat capacity. Therefore, substrate temperature can be changed for a shorter time.

According to the vapor deposition method the heat capacity of the substrate heating heater is larger than that of the substrate. When pressure is changed, therefore, temperature change is more likely in the substrate than in the substrate heating heater. Substrate temperature can be thus more easily changed.

According to the vapor deposition method a clearance is provided between the substrate and the substrate heating heater. Temperature surrounding the substrate thus changes more quickly than that in the substrate heating heater. Due to the temperature of atmosphere surrounding the substrate, therefore, substrate temperature can be more easily set to a predetermined value for a shorter time.

According to the vapor deposition method the tray which has a large heat capacity is not needed in the case of the single substrate carrying type. Heat capacity can be thus made smaller and substrate temperature can be more easily changed for a shorter time. In addition, substrate temperature can be controlled while controlling at least one of the evacuation time and value of pressure set before and after film forming is started in the film forming chamber, the value of pressure set at the film forming time in the film forming chamber, the time for carrying the substrate, and the pressure in the transfer chamber. Therefore, substrate temperature control can be achieved for a shorter time without using any heating or cooling chamber to change the temperature of the substrate. Further, plural different film forming pro processes or steps can be continuously made in a single film forming chamber. Accordingly, the apparatus can be made lower in cost, smaller in size and higher in productivity.

According to the vapor deposition method the film forming chamber has a heater for heating the substrate. Temperature in the film forming chamber can be thus set optional.

According to the vapor deposition method the heating temperature of the heater in the film forming chamber is made constant. Therefore, substrate temperature can be changed for a shorter time because this temperature change is made while keeping constant the heating temperature of the heater which has a relatively large heat capacity.

According to the vapor deposition method substrate temperature is successively controlled in a single film forming chamber and plural different thin film forming processes or steps are continuously carried out in it. Different kinds of thin film layers can be thus more easily laminated in the single film forming chamber.

According to the vapor deposition method at least one layer of semiconductor thin film is included in the thin film layers laminated. Therefore, semiconductor products can be more easily made.

According to the vapor deposition method the substrate is a glass one. It has a low thermal conductivity and temperature gradient is caused in it. Therefore, a temperature of thin film layers can be more easily controlled by the atmosphere surrounding them.

## Claims

1. A vapor deposition method comprising the steps of:
transporting a substrate having a temperature into a film forming chamber provided with a substrate heater that operates at a constant temperature;
controlling the temperature of the substrate by controlling the pressure within the film forming chamber within a range of 13.332 Pa (0.1 Torr) to 666.6 Pa (5 Torr) and/or by controlling the transport time of the heated substrate; and
vapor-depositing a film on the substrate in the film forming chamber using a film forming gas.

2. The vapor deposition method according to claim 1, wherein, after the step of vapor-depositing the film on the substrate in the film forming chamber using the film forming gas, one or more additional films are formed on the substrate by repeatedly controlling the temperature of the substrate by controlling the pressure within the film forming chamber within a range of 13.332 Pa (0.1 Torr) to 666.6 Pa (5 Torr) and vapor-depositing a film on the substrate in the film forming chamber using a film forming gas.

3. The vapor deposition method according to claim 2, wherein, before forming an additional film on the substrate, said substrate is transported from said one film forming chamber into another film forming chamber provided with a substrate heater that operates at a constant temperature, wherein the temperature of the substrate is controlled by controlling the pressure within the other film forming chamber within a range of 13.332 Pa (0.1 Torr) to 666.6 Pa (5 Torr) and/or by controlling the transport time of the substrate from said one film forming chamber into another film forming chamber and wherein the additional film is vapor-deposited on the substrate in the other film forming chamber using a film forming gas.

4. The vapor deposition method according to claim 3, wherein said substrate is transported from the one film forming chamber to the other film forming chamber without being exposed to air.

5. The vapor deposition method according to one of the preceding claims, wherein said vapor deposition is a chemical vapor deposition.

6. The vapor deposition method according to one of the preceding claims, wherein said heater has a heat capacity larger than that of said substrate.

7. The vapor deposition method according to one of the preceding claims, wherein said substrate is disposed to oppose the heater with a clearance.

8. The vapor deposition method according to one of the preceding claims, wherein said heater generates a constant amount of heat.

9. The vapor deposition method according to one of the preceding claims, wherein either one of the films includes a semiconductor thin film.

10. The vapor deposition method according to one of the preceding claims, wherein said substrate is a glass substrate.

11. The vapor deposition method according to one of the preceding claims, wherein said film forming gases contain silane.

12. The vapor deposition method according to one of the preceding claims, wherein said substrate is spaced from said heater.

13. The vapor deposition method according to claim 12, wherein a clearance between said substrate and said heater is smaller than 0.3 mm.

14. The vapor deposition method according to one of the preceding claims, wherein said film is formed of either one of amorphous silicon and silicon nitride.

## Patentansprüche

1. Aufdampfungsverfahren mit den Schritten des
Transportierens bzw. Förderns eines eine (bestimmte) Temperatur aufweisenden Substrats in eine mit einer bei konstanter Temperatur arbeitenden Substrat-Heizeinrichtung versehene Film- bzw. Schichtbildungskammer,
des Steuerns der Temperatur des Substrats durch Steuern des Drucks innerhalb der Filmbildungskammer in einem Bereich von 13,332 Pa (0,1 Torr) bis 666,6 Pa (5 Torr) und/oder durch Steuern der Förderzeit des erwärmten Substrats, sowie des
Aufdampfens eines Films bzw. einer Schicht auf das Substrat in der Filmbildungskammer unter Verwendung eines filmbildenden Gases.

2. Aufdampfungsverfahren nach Anspruch 1, wobei nach dem Schritt des Aufdampfens des Films auf das Substrat in der Filmbildungskammer unter Verwendung des filmbildenden Gases ein oder mehrere zusätzliche Filme auf dem Substrat durch wiederholtesSteuern der Temperatur des Substrats durch Steuern des Drucks innerhalb der Filmbildungskammer in einem Bereich von 13,332 Pa (0,1 Torr) bis 666,6 Pa (5 Torr) und Aufdampfen eines Films auf das Substrat in der Filmbildungskammer unter Verwendung eines filmbildenden Gases gebildet wird bzw. werden.

3. Aufdampfungsverfahren nach Anspruch 2, wobei vor dem Bilden eines zusätzlichen Films auf dem Substrat das Substrat von der einen Filmbildungskammer zu einer anderen Filmbildungskammer transportiert bzw. gefördert wird, die mit einer bei konstanter Temperatur arbeitenden Substrat-Heizeinrichtung versehen ist, wobei die Temperatur des Substrats durch Steuern des Drucks innerhalb der anderen Filmbildungskammer in einem Bereich von 13,332 Pa (0,1 Torr) bis 666,6 Pa (5 Torr) und/oder durch Steuern der Förderzeit des Substrats von der einen Filmbildungskammer zu einer anderen Filmbildungskammer gesteuert wird, und wobei der zusätzliche Film auf dem Substrat in der anderen Filmbildungskammer unter Verwendung eines filmbildenden Gases aufgedampft wird.

4. Aufdampfungsverfahren nach Anspruch 3, wobei das Substrat von der einen Filmbildungskammer zu der anderen Filmbildungskammer gefördert wird, ohne Luft ausgesetzt zu sein.

5. Aufdampfungsverfahren nach einem der vorangehenden Ansprüche, wobei das Aufdampfen ein chemisches Aufdampfen ist.

6. Aufdampfungsverfahren nach einem der vorangehenden Ansprüche, wobei die Heizeinrichtung eine größere Wärmekapazität als die des Substrats aufweist.

7. Aufdampfungsverfahren nach einem der vorangehenden Ansprüche, wobei das Substrat gegenüber der Heizeinrichtung mit einem Abstand angeordnet ist.

8. Aufdampfungsverfahren nach einem der vorangehenden Ansprüche, wobei die Heizeinrichtung eine konstante Wärmemenge erzeugt.

9. Aufdampfungsverfahren nach einem der vorangehenden Ansprüche, wobei jeder der Filme bzw. Schichten eine Halbleiter-Dünnschicht umfaßt.

10. Aufdampfungsverfahren nach einem der vorangehenden Ansprüche, wobei das Substrat ein Glassubstrat ist.

11. Aufdampfungsverfahren nach einem der vorangehenden Ansprüche, wobei die filmbildenden Gase Siliziumwasserstoff enthalten.

12. Aufdampfungsverfahren nach einem der vorangehenden Ansprüche, wobei das Substrat von der Heizeinrichtung beabstandet ist.

13. Aufdampfungsverfahren nach Anspruch 12, wobei ein Abstand zwischen dem Substrat und der Heizeinrichtung kleiner als 0,3 mm ist.

14. Aufdampfungsverfahren nach einem der vorangehenden Ansprüche, wobei der Film bzw. die Schicht entweder aus amorphem Silizium oder aus Siliziumnitrid gebildet ist.

## Revendications

1. Procédé de dépôt en phase vapeur, comprenant les étapes suivantes :
le transport d'un substrat ayant une température dans un chambre de formation de film ayant un organe de chauffage du substrat qui travaille à une température constante,
le réglage de la température du substrat par réglage de la pression dans la chambre de formation de film dans la plage comprise entre 13,332 et 666,6 Pa (0,1 et 5 torr) et/ou par réglage du temps de transport du substrat chauffé, et
le dépôt en phase vapeur d'un film sur le substrat dans la chambre de formation de film à l'aide d'un gaz de formation de film.

2. Procédé de dépôt en phase vapeur selon la revendication 1, dans lequel, après l'étape de dépôt en phase vapeur du film sur le substrat dans la chambre de formation de film à l'aide du gaz de formation de film, un ou plusieurs films supplémentaires sont formés sur le substrat par réglage répété de la température du substrat par réglage de la pression dans la chambre de formation de film dans la plage comprise entre 13,332 et 666,6 Pa (0,1 et 5 torr), et par dépôt en phase vapeur d'un film sur le substrat dans la chambre de formation de film avec un gaz de formation de film.

3. Procédé de dépôt en phase vapeur selon la revendication 2, dans lequel, avant la formation d'un film supplémentaire sur le substrat, le substrat est transporté de la première chambre de formation de film à une autre chambre de formation de film ayant un organe de chauffage de substrat qui travaille à une température constante, dans lequel la température du substrat est réglée par réglage de la pression dans l'autre chambre de formation de film à une valeur comprise dans la plage de 13,332 à 666,6 Pa (0,1 à 5 torr) et/ou par réglage du temps de transport du substrat de la première chambre de formation de film à l'autre chambre de formation de film, et dans lequel le film supplémentaire est déposé en phase vapeur sur le substrat dans l'autre chambre de formation de film avec un gaz de formation de film.

4. Procédé de dépôt en phase vapeur selon la revendication 3, dans lequel le substrat est transporté de la première chambre de formation de film à l'autre chambre de formation de film sans être exposé à l'air.

5. Procédé de dépôt en phase vapeur selon l'une quelconque des revendications précédentes, dans lequel le dépôt en phase vapeur est un dépôt chimique en phase vapeur.

6. Procédé de dépôt en phase vapeur selon l'une des revendications précédentes, dans lequel l'organe de chauffage a une capacité calorifique supérieure à celle du substrat.

7. Procédé de dépôt en phase vapeur selon l'une des revendications précédentes, dans lequel le substrat est disposé en face de l'organe de chauffage avec un espace.

8. Procédé de dépôt en phase vapeur selon l'une des revendications précédentes, dans lequel l'organe de chauffage crée une quantité constante de chaleur.

9. Procédé de dépôt en phase vapeur selon l'une des revendications précédentes, dans lequel l'un des films est un film mince semi-conducteur.

10. Procédé de dépôt en phase vapeur selon l'une des revendications précédentes, dans lequel le substrat est un substrat de verre.

11. Procédé de dépôt en phase vapeur selon l'une des revendications précédentes, dans lequel les gaz de formation de film contiennent un silane.

12. Procédé de dépôt en phase vapeur selon l'une des revendications précédentes, dans lequel le substrat est placé à distance de l'organe de chauffage.

13. Procédé de dépôt en phase vapeur selon la revendication 12, dans lequel l'espace compris entre le substrat et l'organe de chauffage est inférieur à 0,3 mm.

14. Procédé de dépôt en phase vapeur selon l'une des revendications précédentes, dans lequel le film est formé de silicium amorphe ou de nitrure de silicium.
